# EUROPÄISCHE PATENTSCHRIFT

(11) **EP 1 305 988 B1**
(45) Veröffentlichungstag und Bekanntmachung des Hinweises auf die Patenterteilung: **13.09.2006**
(21) Anmeldenummer: 01953922.0
(22) Anmeldetag: 13.07.2001
(51) Int. Cl.: H05K 3/32, H01R 43/02

(54) **VERFAHREN ZUR KONTAKTIERUNG EINER FLEXIBLEN LEITERPLATTE MIT EINEM KONTAKTPARTNER UND ANORDNUNG AUS FLEXIBLER LEITERPLATTE UND KONTAKTPARTNER**
METHOD FOR CONTACTING A FLEXIBLE CIRCUIT BOARD WITH A CONTACT PARTNER AND ARRANGEMENT COMPRISING FLEXIBLE CIRCUIT BOARD AND CONTACT PARTNER
PROCEDE PERMETTANT D'ETABLIR UN CONTACT ENTRE UNE CARTE DE CIRCUITS IMPRIMES SOUPLE ET UN PARTENAIRE DE CONTACT ET ENSEMBLE CARTE DE CIRCUITS IMPRIMES / PARTENAIRE DE CONTACT

(30) Priorität: 28.07.2000 DE 10036900
(43) Veröffentlichungstag der Anmeldung: 02.05.2003
(73) Patentinhaber: SIEMENS AKTIENGESELLSCHAFT, 80333 München (DE)
(72) Erfinder: FRANZEN, Frank, 93077 Bad Abbach (DE); HAUPT, Detlef, 93128 Steinsberg (DE); LOIBL, Josef, 93077 Bad Abbach (DE)
(86) Internationale Anmeldenummer: PCT/DE2001/002638
(87) Internationale Veröffentlichungsnummer: WO 2002/011502

(56) Entgegenhaltungen:
- WO-A-00/49841
- WO-A-98/44593
- DE-A- 4 446 289
- DE-A- 19 504 967
- DE-A- 19 644 121
- US-A- 5 676 865
- PATENT ABSTRACTS OF JAPAN vol. 1999, no. 05, 31. Mai 1999 (1999-05-31) & JP 11 046426 A (HARNESS SOGO GIJUTSU KENKYUSHO:KK;SUMITOMO WIRING SYST LTD; SUMITOMO E), 16. Februar 1999 (1999-02-16)

## Beschreibung

Die Erfindung betrifft ein Verfahren zur Herstellung einer elektrischen Verbindung zwischen einer flexiblen Leiterplatte mit einseitigem Zugriff und einem metallischen Kontaktpartner, eine Anordnung der genannten Elemente mit einer zwischen diesen realisierten elektrischen Verbindungsstelle sowie eine Baugruppe zum vollständigen Einbau in einen Motor oder ein Getriebe eines Kraftfahrzeugs (Kfz), die eine solche elektrische Verbindungsstelle nutzt.

Es ist bereits bekannt, Laserschweißverfahren zur Realisierung einer elektrisch leitenden Verbindung zwischen einer flexiblen Leiterplatte und einem metallischen Leiter einzusetzen. Prinzipielle Vorzüge dieser Technologie bestehen darin, daß keine zusätzlichen Teile wie z.B. Nieten zum Verbindungsaufbau benötigt werden, und daß die Verbindungen in der Herstellung kostengünstig und mit einer hohen Designvariabilität gefertigt werden können.

Für die Praxis ist jedoch nachteilig, daß derzeit Laserschweißungen nur an Leiterplatten mit beidseitigem Zugriff ausgeführt werden können. Darüber hinaus sind neben der Bestrahlung mit Laserlicht häufig weitere Maßnahmen erforderlich, um einen sicheren und mechanisch stabilen Verbindungsaufbau zu garantieren. So ist in der Patentschrift US 5,676,865 ein Laserschweißverfahren beschrieben, bei dem zunächst gegenüberliegende Öffnungen in die boden- und deckenseitigen Isolationsschichten der flexiblen Leiterplatte eingebracht werden, so daß eine zwischenliegend verlaufende Leiterbahn in den Öffnungsbereichen beidseitig freiliegt. Die freiliegende Leiterbahn wird dann mit einem Zentralloch reduzierten Durchmessers versehen. Der Lochrand der Leiterbahn wird umgeformt, so daß er mit einem elektrischen Leiter in Kontakt gelangt, auf dem die flexible Leiterplatte mit einer Seite aufliegt. Die Verschweißung der Leiterbahn mit dem Leiter erfolgt im umgeformten Lochrandbereich mittels eines Lasers.

Bei diesem Verfahren ist problematisch, daß aufgrund des Zentrallochs gelegentlich nicht ausreichend Leiterbahnmaterial für eine sichere und dauerhafte Schweißverbindung zur Verfügung steht.

Um diesbezüglich Abhilfe zu schaffen, wird in der nicht vorveröffentlichten deutschen Patentanmeldung DE 199 06 807 ein Verfahren vorgeschlagen, das es ermöglicht, ohne eine mechanische Bearbeitung (z.B. Lochstanzung, Umformung) der Leiterbahn eine Schweißverbindung zwischen dieser und einem Kontaktpartner zu erzeugen. Auch bei diesem Verfahren muß jedoch der Zugriff auf die Leiterbahn von beiden Seiten gegeben sein. Nachteilig daran ist, daß Leiterplatten mit beidseitigem Zugriff wesentlich teuerer als Leiterplatten vergleichbarer Größe und Bauart mit einseitigem Zugriff sind. Ursache hierfür ist, daß Leiterplatten mit einseitigem Zugriff in einem kostengünstigen, sogenannten Rolle-zu-Rolle-Prozeß am kontinuierlichen Material herstellbar sind, während Leiterplatten mit beidseitigem Zugriff (aufgrund der hohen Anforderungen an die Ausrichtungsgenauigkeit bezüglich der gegenüberliegenden Zugriffsöffnungen) aus Einzelmaterialabschnitten hergestellt werden müssen.

Der Erfindung liegt die Aufgabe zugrunde, ein Verfahren zur Herstellung einer elektrischen Verbindung zwischen einer flexiblen Leiterplatte und einem metallischen Kontaktpartner anzugeben, das einfach und kostengünstig durchzuführen ist und gleichzeitig eine mechanisch stabile und elektrisch sichere Verbindung realisiert. Insbesondere soll die mittels des Verfahrens geschaffene Verbindungsstelle auch für eine Kontaktierung von elektrischen Bauteilen unter erschwerten Umgebungsbedingungen, wie sie beispielsweise in einem Getriebe oder einem Motor eines Kfz herrschen, geeignet sein.

Die der Erfindung zugrundeliegende Aufgabenstellung wird durch die Merkmale der unabhängigen Ansprüche gelöst.

Ein wesentlicher Gesichtspunkt der Erfindung besteht darin, daß das Verfahren eine flexible Leiterplatte mit einseitigem Zugriff nutzt, d.h. daß im Rahmen der Erfindung herausgefunden wurde, daß die Laserlichtbestrahlung zur Herstellung des Schweißgefüges unmittelbar durch die zweite Isolationsschicht hindurch erfolgen kann. Damit erübrigt es sich, bereits bei der Herstellung der Leiterplatte an der später zu bestrahlenden Stelle in der zweiten Isolationsschicht eine Aussparung vorzusehen oder an der fertig hergestellten flexiblen Leiterplatte durch lokales Entfernen der zweiten Isolationsschicht nachträglich einen doppelseitigen Zugriff an dieser Stelle zu schaffen.

Im Rahmen der Erfindung durchgeführte Untersuchungen zeigen, daß bei üblichen in der Leiterplattenfertigung eingesetzten Kunststoffolien (z.B. Polyimidfolie) und bei Verwendung eines Nd:YAG-Lasers (Wellenlänge 1,06 µm) das Laserlicht die Kunststoffolie (zweite Isolationsschicht) nahezu ohne Energieverlust durchdringt und eine Energieabsorption erst beim Auftreffen des Lichts auf die insbesondere als Kupferschicht realisierte Leiterbahn auftritt. Dabei führt die bei der Schweißung eingebrachte Energie zu einem praktisch schlagartigen Aufschmelzen der Leiterbahn und zu einem Eindringen des Laserstrahls in den Anlagebereich des Kontaktpartners. Für die Qualität der beim Schweißvorgang gebildeten Verbindung spielt die Tiefe des Eindringens des Laserstrahls in den Kontaktpartner eine wichtige Rolle. Vermag der Laserstrahl nicht in den Kontaktpartner einzudringen, d.h. wenn lediglich die Leiterbahn aufgeschmolzen wird, wird kein befriedigendes Schweißergebnis erreicht. Dringt der Laserstrahl andererseits in den Kontaktpartner ein, tritt ein Effekt auf, der als Tiefschweißeffekt bezeichnet wird. Dieser besteht darin, daß das Kontaktpartnermaterial schlagartig aufgeschmolzen wird und man ein mehr oder weniger eruptives Verhalten der Metallschmelze beobachtet. Das eruptive Verhalten führt zu einem Wegspritzen von aufgeschmolzenem Kontaktpartnermaterial, wobei sich durch den Materialverlust im zentralen Bereich des Kontaktpartners eine Mulde ausbildet. Als Folge der Muldenausbildung wird ein ringförmiger Schweißbereich erhalten, der unerwünscht ist, weil je nach Größe der Ringöffnung ein Teil der zur Verfügung stehenden Schweißfläche ungenutzt bleibt. Vorzugsweise wird das erfindungsgemäße Verfahren daher so durchgeführt, daß ein die Güte der Schweißverbindung optimierender Tiefschweißeffekt erreicht wird, was bedeutet, daß zwar ein Aufschmelzen der Kontaktpartneroberfläche stattfindet, ein Wegspritzen von Metallschmelze jedoch weitestgehend oder vollständig vermieden wird. Im Idealfall wird dadurch ein vollflächiger (kreisscheibenförmiger) Schweißbereich erzielt, wobei ein ringförmiger Schweißbereich mit vergleichsweise kleiner Ringöffnung auch noch tolerierbar sein kann.

Zur Erzielung eines die Güte der Schweißverbindung optimierenden Tiefschweißeffektes wird der Laser vorzugsweise so betrieben, daß die Aufschmelztiefe der Kontaktpartneroberfläche zwischen 0,5 und 1 mm beträgt.

Die Ausprägung des Tiefschweißeffekts wird durch eine Vielzahl von Parametern beeinflußt. Vorteilhafte Wertebereiche für die Parameter Schweißenergie, Pulsleistung, Schweißzeit und Lichtfleckdurchmesser, die zu Schweißverbindungen mit guter mechanischer und elektrischer Festigkeit führen, sind in den Unteransprüchen angegeben.

Eine weitere vorteilhafte Verfahrensmaßnahme kennzeichnet sich dadurch, daß zum Aufbau der Schweißverbindung mehrere lageversetzt auf die zweite Isolationsschicht aufgebrachte Laserlichtpulse eingesetzt werden. Durch den Lageversatz (der entsprechenden Lichtflecke auf der zweiten Isolationsschicht) wird eine effektive Vergrößerung des Schweißbereichs erreicht, was zu einer Erhöhung der Festigkeit der Verbindung führt.

Eine wichtige technische Anwendung der erfindungsgemäßen Anordnung mit elektrischer Verbindungsstelle besteht in der Kontaktierung von elektrischen Verdrahtungselementen oder in der Direktkontaktierung von Elektrobauteilen, die gemeinsam mit einem Steuergerät in einem Motor oder Getriebe eines Kfz untergebracht sind. Für derartige mechatronische Steuerungssysteme wurde kürzlich ein technisches Konzept entwickelt, bei dem eine in dem Steuergerätgehäuse untergebrachte elektronische Schaltung über eine durch einen Dichtspalt des Gehäuses nach außen geführte flexible Leiterplatte mit elektrischen Verdrahtungselementen oder direkt mit Anschlußbeinen von in dem Getriebe oder Motor befindlichen Sensoren und/oder Aktoren verbunden ist. Für diese Technologie schafft die erfindungsgemäße Anordnung eine geeignete und kostengünstige Möglichkeit einer elektrischen Kontaktierung zwischen den genannten Elementen, wobei die geschaffene Schweißverbindung in überraschender Weise dermaßen widerstandsfähig ist, daß sie den in einem Getriebe oder Motor herrschenden Umgebungsbedingungen (Temperaturbereich von etwa -40°C bis 150°C, Vibrationen bis etwa 40 g) standzuhalten vermag.

Weitere vorteilhafte Ausgestaltungen der Erfindung sind in den Unteransprüchen angegeben.

Die Erfindung wird nachfolgend anhand eines Ausführungsbeispiels und Ausführungsvarianten desselben unter Bezugnahme auf die Zeichnung erläutert, in dieser zeigt:
- Fig. 1: eine schematische Schnittdarstellung einer flexiblen Leiterplatte und einem metallischen Kontaktpartner zu einem Zeitpunkt unmittelbar vor dem Aufbau der erfindungsgemäßen Schweißverbindung;
- Fig. 2: einen Ausschnitt der in Fig. 1 gezeigten flexiblen Leiterplatte in Draufsicht auf die die Zugriffsöffnung aufweisende erste Isolationsschicht;
- Fig. 3: eine schematische Schnittdarstellung einer Anordnung bestehend aus Getriebesteuergerät, flexibler Leiterplatte und direkt an die Leiterplatte ankontaktiertem Elektrobauteil; und
- Fig. 4a, 4b: Perspektivansichten der in Fig. 3 gezeigten Verbindung zwischen flexibler Leiterplatte und Elektrobauteil von seitlich oberhalb bzw. seitlich unterhalb der Leiterplatte.

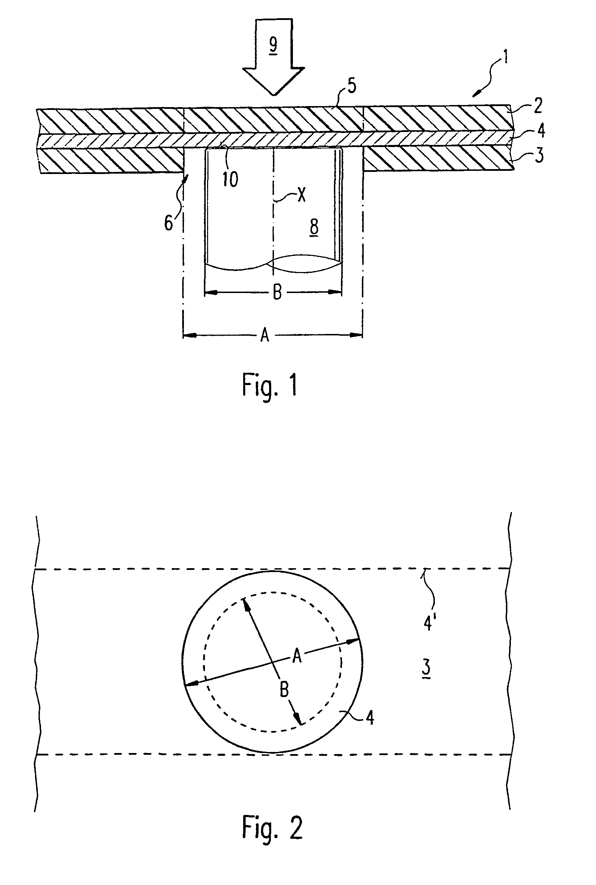

Nach Fig. 1 umfaßt eine flexible Leiterplatte 1 eine erste Isolationsschicht 3 und eine zweite Isolationsschicht 2, zwischen denen eine Leiterbahn 4 eingebettet ist.

Die Leiterbahn 4 kann beispielsweise aus Cu bestehen, die Isolationsschichten 2, 3 können aus gängigen bei der Leiterplattenfertigung verwendeten Kunststoffolien, wie z.B. Polyimidfolien, bestehen und eine Dicke von etwa 25 oder auch 50 µm aufweisen. Zwischen der Leiterbahn 4 und den Isolationsschichten 2, 3 kann je nach Bauart der Leiterplatte 1 in nicht dargestellter Weise ein Acryl- oder Epoxidharzkleber vorhanden sein.

In der ersten Isolationsschicht 3 ist eine Zugriffsöffnung 6 ausgebildet. Der entsprechende, der Zugriffsöffnung 6 gegenüberliegende Bereich 5 in der zweiten Isolationsschicht 2 ist intakt, d.h. die Leiterbahn 4 ist im Bereich der zu fertigenden Kontaktstelle auf der der Zugriffsöffnung 6 abgewandten Seite von der zweiten Isolationsschicht 2 vollständig abgedeckt.

Derartige flexible Leiterplatten, die ausschließlich auf einer Seite mit Zugriffsöffnungen versehen sind, werden in der Technik als Leiterplatten mit einseitigem Zugriff bezeichnet. Wie bereits erwähnt sind sie wesentlich kostengünstiger als Leiterplatten mit beidseitigem Zugriff (d.h. Leiterplatten, bei denen Zugriffsöffnungen in beiden Isolationsschichten 2 und 3 vorhanden sind) produzierbar, weil das Anheften der einzelnen Schichten 2 (Basismaterial), 4 (Metallfolie) und 3 (Deckfolie) sowie Strukturierungsschritte zum Herausbilden von Leiterbahnen 4 aus der Metallfolie an kontinuierlichen Materialbahnen durchführbar ist (sog. Rolle-zu-Rolle-Prozeß). Die Zugriffsöffnungen 6 in der Deckfolie 4 können dabei entweder bereits vor dem Zusammenfügen der Folien 2, 3, 4 in der Deckfolie (entspricht erster Isolationsschicht 3) vorgefertigt sein oder sie können nach dem Aufbau des Leiterplattenverbunds auch nachträglich durch Abtragen von Deckfolienmaterial in die Deckfolie (erste Isolationsschicht 3) eingebracht werden.

Unterhalb der Leiterbahn 4 befindet sich ein mit der Leiterbahn 4 zu verschweißender, metallischer, z.B. zylinderförmiger Kontaktpartner 8. Der Kontaktpartner 8 kann aus einer Cu-Legierung, beispielsweise CuSn 4/5/6, bestehen.

Vor Durchführung des Schweißschrittes werden die flexible Leiterplatte 1 und der Kontaktpartner 8 in der Weise aneinander angenähert, daß eine Stirnfläche 10 des Kontaktpartners 8 ganzflächig an die Leiterbahn 4 anliegt. Die Mittenlängsachse X des Kontaktpartners 8 verläuft in Normalrichtung zur Leiterbahnebene. Eine vorbereitende Bearbeitung der Leiterbahn 4 (z.B. eine Umformung oder eine Perforation derselben) entfällt, die Leiterbahn 4 verbleibt wie in Fig. 1 dargestellt im wesentlichen plan.

Fig. 2 zeigt in Draufsicht die Konturlinie 4' der Leiterbahn 4 und verdeutlicht, daß der Durchmesser B der Stirnfläche 10 des Kontaktpartners 8 kleiner als der Öffnungsdurchmesser A der Zugriffsöffnung 6 (beispielsweise 3 mm) ist.

In einem nächsten Schritt wird mittels eines Lasers Laserlicht 9 auf den die Leiterbahn 4 rückseitig abdeckenden Bereich 5 der zweiten Isolationsschicht 2 gestrahlt. Vorzugsweise wird ein zur Leiterbahnebene senkrechter Lichteinfall mit einer optischen Achse gewählt, die mit der Mittenlängsachse X zusammenfällt. Bei Verwendung eines Nd:YAG-Lasers mit einer Wellenlänge von 1,06 µm und einer mittleren Leistung von 30-500 W haben sich für das Schweißen durch ein Polyimidmaterial (zweite Isolationsschicht 2) die folgenden Parameter als geeignet erwiesen:
- Schweißenergie: 7-11 J
- Pulsleistung: 1-3 kW
- Schweißzeit: 3-10 ms
- Durchmesser des vom Laser auf der zweiten Isolationsschicht 2 erzeugten Lichtflecks: 0,3-0,6 mm

Mit in diesen Bereichen liegenden Parameterwerten konnte eine für den Aufbau der Schweißverbindung ausreichende Energiemenge in das System eingekoppelt und der Tiefschweißeffekt weitestgehend optimiert werden, wobei eine Aufschmelztiefe der Kontaktpartneroberfläche von etwa 0,5-1mm erhalten wurde. Im Ergebnis konnten Schweißverbindungen mit guter mechanischer Festigkeit und geringem elektrischen Übergangswiderstand hergestellt werden.

Im Rahmen der durchgeführten Versuche wurde festgestellt, daß sich die Qualität der Schweißung ferner durch die Einflußgrößen Auftreffwinkel des Laserstrahls, Fokuslage und Oxidationsgrad der Cu-Leiterbahn 4 beeinflussen läßt. Weitere Einflußgrößen sind der Durchmesser B des Kontaktpartners 8 sowie - bei Verwendung eines stirnseitig versilberten Kontaktpartners 8 - die Dicke dieser Silberschicht (nicht dargestellt).

Es wird darauf hingewiesen, daß sich die genannten Parameter und Einflußgrößen zumindest teilweise gegenseitig beeinflussen, d.h. in Bezug auf die Minimierung des Tiefschweißeffektes abhängig voneinander optimiert werden müssen.

Wie bereits erwähnt, werden bei idealer Wahl der Parameter Schweißstellen mit einer vollflächigen, im wesentlichen kreisscheibenförmigen Verbindungszone geschaffen. An der Rückseite der Schweißstelle kommt es dabei zu einer thermischen Beschädigung der zweiten Isolationsschicht 2 im Abdeckungsbereich 5, wobei der sich dort einstellende Materialverlust nicht infolge von Aborptionsprozessen bei der Laserbestrahlung einstellt, sondern infolge der thermischen Aufheizung der Leiterbahn 4 und der dadurch bedingten Verdampfung von Isolationsschichtmaterial auftritt.

Eine weitere Verbesserung der Festigkeit des erhaltenen Schweißgefüges kann durch den Einsatz von Laserlicht-Doppelpulsen erreicht werden, die auf unterschiedliche, innerhalb der Kontur der gegenüberliegenden Zugriffsöffnung 6 liegende Stellen der Deckfolie 3 gerichtet werden.

Eine wichtige technische Anwendung der erfindungsgemäßen Anordnung aus Leiterplatte 4 und Kontaktpartner 8 mit elektrischer Verbindungsstelle betrifft die Kontaktierung von Verdrahtungselementen (z.B. Stanzgittern) oder Elektrobauteilen, die mit einem elektronischen Steuergerät in einem Motor oder Getriebe eines Kfz untergebracht sind.

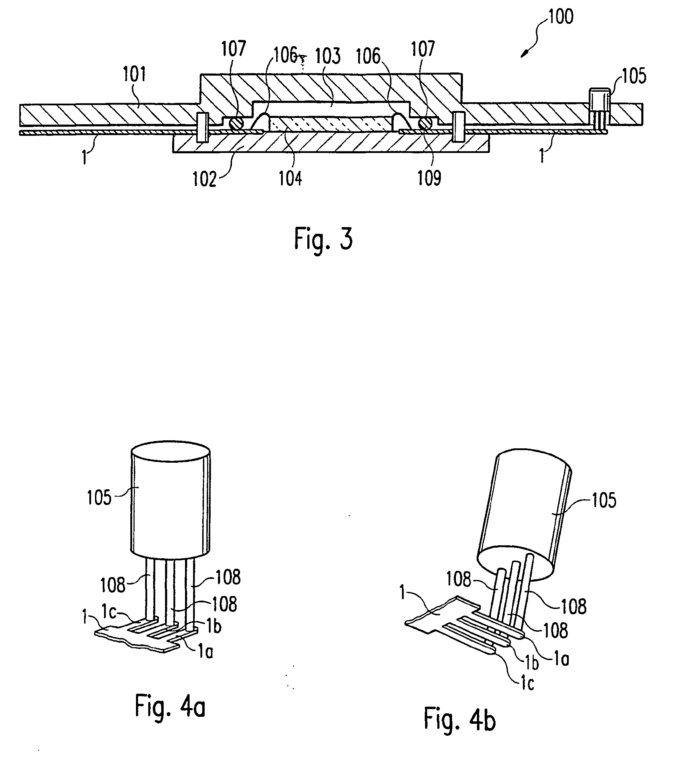

Fig. 3 zeigt in beispielhafter Weise ein Getriebesteuergerät 100. Das Getriebesteuergerät 100 umfaßt einen Gehäusedeckel 101 und eine metallische Bodenplatte 102. Der Gehäusedeckel 101 und die Bodenplatte 102 umschließen einen Hohlraum 103. In dem Hohlraum 103 befindet sich ein Schaltungsträger 104, auf dem eine elektronische Schaltung realisiert ist. Als Schaltungsträger 104 kann ein Keramiksubstrat vorgesehen sein, das mit einem Wärmeleitkleber auf die als Wärmesenke dienende metallische Bodenplatte 102 aufgeklebt ist.

Der Schaltungsträger 104 ist allseitig von einer flexiblen Leiterplatte 1 umgeben, die entsprechend der bisherigen Beschreibung hergestellt und ausgeführt ist. Die nicht dargestellten Leiterbahnen 4 der flexiblen Leiterplatte 1 sind über Bonddrähte 106 oder auch über direkte elektrische Kontaktklebungen mit entsprechenden Kontaktpads auf dem Schaltungsträger 104 verbunden. Einzelheiten des Aufbaus hinsichtlich der Verbindung zwischen der elektronischen Schaltung und der flexiblen Leiterplatte und der Gehäusedurchführung sind in der WO 98/44593 beschrieben und werden durch Bezugnahme zum Inhalt der vorliegenden Schrift.

Der Gehäusedeckel 101 weist eine umlaufende, stufenförmige oder als Nut ausgebildete Dichtfläche 107 auf, an die eine Ringdichtung 109 anliegt. Die flexible Leiterplatte 1 ist zwischen der Ringdichtung 109 und der metallischen Bodenplatte 102 aus dem Hohlraum 103 des Steuergerätgehäuses 101, 102 herausgeführt.

Der Gehäusedeckel 101 ist als Tragkörper des Steuergeräts 100 ausgeführt und bildet darüber hinaus eine Montageplatte für außerhalb des Hohlraums 103 angeordnete Elektrobauteile. Als Beispiel für ein Elektrobauteil ist in Fig. 3 ein Temperatursensor 105 dargestellt, der in einer Montageöffnung des Gehäusedeckels 101 befestigt ist.

Die flexible Leiterplatte 1 ist an der Unterseite des Gehäusedeckels 101 zu dem Temperatursensor 105 hingeführt und kontaktiert dort mittels in erfindungsgemäßer Weise hergestellter Schweißstellen Anschlußbeine 108 des Temperatursensors 105. Die Anschlußbeine 108 realisieren die Kontaktpartner 8.

Die Fig. 4a und 4b zeigen in perspektivischen Ansichten die Verbindung zwischen der flexiblen Leiterplatte 1 und den Anschlußstiften 108. Es wird deutlich, daß die flexible Leiterplatte 1 mit umfangsseitig hervorstehenden Fingern 1a, 1b, 1c zur Kontaktierung der Anschlußbeine 108 ausgeführt sein kann.

Zusammenfassend ist festzustellen, daß durch die Verwendung einer kostengünstigen Leiterplatte 1 mit einseitigem Zugriff und den Einsatz eines kostengünstigen Direktmontageprozesses durch Laserschweißen bei dem in den Fig. 3, 4a und 4b gezeigten Anwendungsbeispiel - besonders bei einer Herstellung in Großserie - deutliche Kosteneinsparungen ermöglicht werden.

Alternativ zu der in den Fig. 3, Fig. 4a und Fig. 4b gezeigten Direktkontaktierung von Bauteilen 105 kann die Leiterplatte 1 in analoger Weise auch mit den Enden von im Getriebe oder im Motor verlaufenden elektrischen Verdrahtungselementen, beispielsweise Stanzgittern, verbunden sein.

## Patentansprüche

1. Verfahren zur Herstellung einer elektrischen Verbindung zwischen einer flexiblen Leiterplatte (1) mit einseitigem Zugriff und einem metallischen Kontaktpartner (8, 108), mit den Schritten:
- Bereitstellen der zwei Isolationsschichten (2, 3) und wenigstens eine dazwischen verlaufende, metallische Leiterbahn (4) umfassenden flexiblen Leiterplatte (1), in deren erster Isolationsschicht (3) eine die Leiterbahn (4) freilegende Zugriffsöffnung (6) ausgebildet ist;
- Annähern des metallischen Kontaktpartners (8, 108) und der Leiterplatte (1), derart, daß der metallische Kontaktpartner (8, 108) durch die Zugriffsöffnung (6) hindurch in Anlage an die metallische Leiterbahn (4) gebracht wird; und
- Bestrahlen der zweiten Isolationsschicht (2) an einem der Zugriffsöffnung (6) gegenüberliegenden Ort (5) mit Laserlicht (9), wobei eine Schweißverbindung zwischen dem Kontaktpartner (8, 108) und der Leiterbahn (4) ausgebildet wird.

2. Verfahren nach Anspruch 1,
**dadurch gekennzeichnet,**
- **daß** der Schweißvorgang so durchgeführt wird, daß das Auftreten eines ringförmigen Schweißbereichs zwischen der Leiterbahn (4) und dem Kontaktpartner (8, 108) weitestgehend oder vollständig vermieden wird.

3. Verfahren nach Anspruch 1 oder 2,
**dadurch gekennzeichnet,**
- **daß** der Schweißvorgang so durchgeführt wird, daß durch die Laserlichtbestrahlung eine Aufschmelztiefe der Kontaktpartneroberfläche zwischen 0,5 und 1 mm erhalten wird.

4. Verfahren nach einem der vorhergehenden Ansprüche,
**dadurch gekennzeichnet,**
- **daß** ein Nd:YAG-Laser als Laserlichtquelle eingesetzt und mit einer mittleren Leistung im Bereich von 30 bis 500 W betrieben wird.

5. Verfahren nach einem der vorhergehenden Ansprüche,
**dadurch gekennzeichnet,**
- **daß** mittels einer im Strahlengang des Lasers liegenden Optik ein Lichtfleck mit einem Durchmesser zwischen 0,3 und 0,6 mm auf der zweiten Isolationsschicht (2) erzeugt wird.

6. Verfahren nach einem der vorhergehenden Ansprüche,
**dadurch gekennzeichnet,**
- **daß** eine Schweißenergie von 7 bis 11 J während einer Schweißdauer von 3 bis 10 ms aufgebracht wird.

7. Verfahren nach einem der vorhergehenden Ansprüche,
**dadurch gekennzeichnet,**
- **daß** ein gepulster Nd:YAG-Laser mit einer Pulsleistung von 1 bis 3 kW eingesetzt wird.

8. Verfahren nach einem der vorhergehenden Ansprüche,
**dadurch gekennzeichnet,**
- **daß** zum Aufbau der Schweißverbindung mehrere lageversetzt auf die zweite Isolationsschicht (2) aufgebrachte Laserlichtpulse eingesetzt werden.

9. Verfahren nach einem der vorhergehenden Ansprüche,
**dadurch, gekennzeichnet,**
- **daß** der Kontaktpartner (8, 108) eine versilberte Anlageoberfläche aufweist.

10. Anordnung aus einer flexiblen Leiterplatte (1) mit einseitigem Zugriff, einem metallischen Kontaktpartner (8, 108) und einer elektrischen Verbindungsstelle zwischen der flexiblen Leiterplatte (1) und dem metallischen Kontaktpartner (8, 108), bei der
- die flexible Leiterplatte (1) aus zwei Isolationsschichten (2, 3) und wenigstens einer dazwischen verlaufenden metallischen Leiterbahn (4) aufgebaut ist,
- in einer ersten Isolationsschicht (3) eine Zugriffsöffnung (6) ausgebildet ist,
- der metallische Kontaktpartner (8, 108) durch die Zugriffsöffnung (6) hindurchragt und dort mit der metallischen Leiterbahn (4) verschweißt ist, und
- in der zweiten Isolationsschicht (2) gegenüberliegend der Zugriffsöffnung (6) ein durch die zur Verschweißung eingesetzte Laserlichtbestrahlung herbeigeführter Brandbeschädigungsbereich vorliegt.

11. Baugruppe zum vollständigen Einbau in einen Motor oder ein Getriebe eines Kraftfahrzeugs,
- mit einem Steuergerät (100), das ein öldichtes Gehäuse (101, 102) aufweist, in dem eine elektronische Schaltung untergebracht ist,
- mit einer flexiblen Leiterplatte (1), die mit der elektronischen Schaltung in elektrischer Verbindung steht und durch einen Dichtspalt des Gehäuses (101, 102) nach außen geführt ist, und
- mit außerhalb des Steuergerätes (100) vorgesehenen elektrischen Anschlüssen (108), die gemäß einer Anordnung nach Anspruch 10 als Kontaktpartner mit der flexiblen Leiterplatte (1) verbunden sind.

12. Baugruppe nach Anspruch 11,
**dadurch gekennzeichnet,**
**daß** die elektrischen Anschlüsse (108) durch ein metallisches Stanzgitter realisiert sind.

## Claims

1. Method for producing an electrical connection between a flexible circuit board (1) with single-sided access and a metallic contact partner (8, 108), with the steps of:
- providing the flexible circuit board (1), comprising two insulating layers (2, 3) and at least one metallic conductor strip (4) running in between, in the first insulating layer (3) of which there is formed an access opening (6) exposing the conductor strip (4);
- bringing the metallic contact partner (8, 108) and the circuit board (1) towards each other in such a way that the metallic contact partner (8, 108) is brought to bear against the metallic conductor strip (4) through the access opening (6); and
- irradiating the second insulating layer (2) with laser light (9) at a location (5) lying opposite the access opening (6), a welded connection being formed between the contact partner (8, 108) and the conductor strip (4).

2. Method according to Claim 1, **characterized in that**
- the welding operation is carried out in such a way that the occurrence of an annular welding region between the conductor strip (4) and the contact partner (8, 108) is avoided to the greatest extent or completely.

3. Method according to Claim 1 or 2, **characterized**
- **in that** the welding operation is carried out in such a way that a melting depth of the surface of the contact partner of between 0.5 and 1 mm is obtained by the laser light irradiation.

4. Method according to one of the preceding claims, **characterized**
- **in that** an Nd:YAG laser is used as the laser light source and is operated at an average power in the range from 30 to 500 W.

5. Method according to one of the preceding claims, **characterized**
- **in that** a light spot with a diameter of between 0.3 and 0.6 mm is produced on the second insulating layer (2) by means of an optical system lying in the beam of the laser.

6. Method according to one of the preceding claims, **characterized**
- **in that** a welding energy of from 7 to 11 J is applied during a welding period of from 3 to 10 ms.

7. Method according to one of the preceding claims, **characterized**
- **in that** a pulsed Nd:YAG laser with a pulse power of 1 to 3 kW is used.

8. Method according to one of the preceding claims, **characterized**
- **in that** a number of laser light pulses applied to the second insulating layer (2) in a positionally offset manner are used for creating the welded connection.

9. Method according to one of the preceding claims, **characterized**
- **in that** the contact partner (8, 108) has a silvered bearing surface.

10. Arrangement comprising a flexible circuit board (1) with single-sided access, a metallic contact partner (8, 108) and an electrical connecting point between the flexible circuit board (1) and the metallic contact partner (8, 108), in which
- the flexible circuit board (1) is constructed from two insulating layers (2, 3) and at least one metallic conductor strip (4) running in between,
- an access opening (6) is formed in a first insulating layer (3),
- the metallic contact partner (8, 108) protrudes through the access opening (6) and is welded there to the metallic conductor strip (4), and
- a fire damage region, brought about by the laser light irradiation used for the welding, is present in the second insulating layer (2), lying opposite the access opening (6).

11. Module for complete installation in an engine or a gearbox of a motor vehicle,
- with a control device (100) which has an oiltight housing (101, 102), in which an electronic circuit is accommodated,
- with a flexible circuit board (1), which is in electrical connection with the electronic circuit and is led to the outside through a sealing gap in the housing (101, 102), and
- with electrical terminals (108) which are provided outside the control device (100) and are connected as a contact partner to the flexible circuit board (1) in the way according to an arrangement according to Claim 10.

12. Module according to Claim 11, **characterized in that** the electrical terminals (108) are realized by a metallic leadframe.

## Revendications

1. Procédé pour la réalisation d'une liaison électrique entre une plaquette de circuits imprimés (1) flexible avec un accès sur une face et un partenaire de contact (8, 108) métallique, comportant les étapes :
- préparation des deux couches isolantes (2, 3) et d'au moins une plaquette de circuits imprimés (1) flexible intercalée et comportant une piste conductrice (4) métallique, une ouverture d'accès (6), mettant à découvert la piste conductrice (4), étant réalisée dans la première couche isolante (3),
- rapprochement du partenaire de contact (8, 108) métallique et de la plaquette de circuits imprimés (1), de telle sorte que le partenaire de contact (8, 108) métallique est amené à travers l'ouverture d'accès (6) en appui contre la piste conductrice (4) métallique ; et
- projection d'une lumière laser (9) sur la deuxième couche isolante (2) dans une zone (5) en face de l'ouverture d'accès (6), un assemblage soudé étant réalisé entre le partenaire de contact (8, 108) et la piste conductrice (4).

2. Procédé selon la revendication 1, **caractérisé en ce que** le processus de soudage est effectué de telle sorte que la formation d'une zone soudée annulaire est largement ou complètement évitée entre la piste conductrice (4) et le partenaire de contact (8, 108).

3. Procédé selon la revendication 1 ou 2, **caractérisé en ce que** le processus de soudage est effectué de telle sorte que, sous l'effet de la projection de la lumière laser, la surface du partenaire de contact est mise en fusion avec une profondeur entre 0,5 et 1 mm.

4. Procédé selon l'une quelconque des revendications précédentes, **caractérisé en ce qu'**un laser Nd:YAG est utilisé comme source de lumière laser et est exploité avec une puissance moyenne dans le domaine de 30 à 500 W.

5. Procédé selon l'une quelconque des revendications précédentes, **caractérisé en ce qu'**un point lumineux avec un diamètre entre 0,3 et 0,6 mm est généré sur la deuxième couche isolante (2) au moyen d'un élément optique situé dans la trajectoire du rayon laser.

6. Procédé selon l'une quelconque des revendications précédentes, **caractérisé en ce qu'**une énergie de soudage de 7 à 11 J est appliquée pendant une durée de soudage de 3 à 10 ms.

7. Procédé selon l'une quelconque des revendications précédentes, **caractérisé en ce que** l'on utilise un laser Nd:YAG pulsé avec une puissance d'impulsion de 1 à 3 kW.

8. Procédé selon l'une quelconque des revendications précédentes, **caractérisé en ce que**, pour la réalisation de l'assemblage soudé, on utilise plusieurs impulsions de lumière laser appliquées de manière décalée en position sur la deuxième couche isolante (2).

9. Procédé selon l'une quelconque des revendications précédentes, **caractérisé en ce que** le partenaire de contact (8, 108) comporte une surface d'appui revêtue d'une couche d'argent.

10. Agencement formé par une plaquette de circuits imprimés (1) flexible avec accès sur une face, un partenaire de contact (8, 108) métallique et une zone de liaison électrique entre la plaquette de circuits imprimés (1) flexible et le partenaire de contact (8, 108) métallique, dans lequel :
- la plaquette de circuits imprimés (1) flexible est formée par deux couches isolantes (2, 3) et au moins une piste conductrice (4) métallique, intercalée entre celles-ci,
- une ouverture d'accès (6) est réalisée dans une première couche isolante (3),
- le partenaire de contact (8, 108) métallique passe à travers l'ouverture d'accès (6) et y est soudé avec la piste conductrice (4) métallique, et
- une zone due à un endommagement thermique, généré par la projection de la lumière laser utilisée pour le soudage, est disposée dans la deuxième couche isolante (2) en face de l'ouverture d'accès (6).

11. Groupe de construction destiné à être monté intégralement dans un moteur ou une boîte de vitesses d'un véhicule automobile,
- avec un dispositif de commande (100), qui comporte un boîtier (101, 102) étanche à l'huile, dans lequel est monté un circuit électronique,
- avec une plaquette de circuits imprimés (1) flexible, qui est en liaison électrique avec le circuit électronique et qui est guidée vers l'extérieur à travers une fente d'étanchéité du boîtier (101, 102), et
- avec des connexions électriques (108), qui sont prévues en dehors du dispositif de commande (100) et qui, sous forme de partenaire de contact, sont reliées à la plaquette de circuits imprimés (1) flexible selon un agencement selon la revendication 10.

12. Groupe de construction selon la revendication 11, **caractérisé en ce que** les connexions électriques (108) sont formées par un grillage métallique estampé.
